# EUROPEAN PATENT SPECIFICATION

(11) **EP 1 904 898 B1**
(45) Date of publication and mention of the grant of the patent: **17.08.2011**
(21) Application number: 06743068.6
(22) Date of filing: 26.05.2006
(51) Int. Cl.: G03F 7/42

(54) **METHOD FOR FINE LINE RESIST STRIPPING**
VERFAHREN ZUR FEINLINIEN-RESIST-ENTFERNUNG
PROCEDE DE DECAPAGE DE RESERVES EN LIGNES FINES

(30) Priority: 03.06.2005 EP 05012012
(43) Date of publication of application: 02.04.2008
(73) Proprietor: ATOTECH Deutschland GmbH, 10553 Berlin (DE)
(72) Inventor: SPARING, Christian, 13509 Berlin (DE); TEWS, Dirk, 10439 Berlin (DE); WOOD, Neal, Reddich Worcestershire B98 8HX (GB)
(74) Representative: Albrecht, Thomas
(86) International application number: PCT/EP2006/005041
(87) International publication number: WO 2006/128642

(56) References cited:
- EP-A- 0 547 488
- US-A- 4 786 578

## Description

### Description of the invention

The present invention relates to a method for stripping of dryfilm and photoresist material from a substrate. The substrate generally is a semiconductor-device or a printed circuit board.

### Background of the invention

Integrated circuit manufacturing technology utilizes positive photoresist type material for photolithographically delineating patterns on substrates which later on in the process are etched by wet or dry etching techniques.

Imaging is the process that patterns the metal conductor to form the circuit. This process involves a multistep integration of imaging materials, imaging equipment, and processing conditions with the metallization process to reproduce the master pattern on a substrate. Large features (200 µm and greater) can be very economically formed by screen printing. Feature sizes smaller than 200 µm, however, are formed using a photolithographic process. As circuit densities have increased over the years, the imaging process has continually evolved to enable commercial production of finer features. This need for high-density interconnect (HDI) is driving the industry with feature sizes of 50 µm or lower. Imaging equipment and materials have been developed to meet this challenge.

The photolithographic process sequence for imaging basically involves applying a light-sensitive polymeric material (photoresist) onto the substrate of interest, exposing this photoresist to light with the desired pattern, and developing the exposed pattern. This developed pattern is used for either subtractive (etching) or additive (plating) metal pattern transfer. After metallization, the photoresist is stripped from the surface and the panel is ready for further processing.

It is necessary in such a full lithographic process that the photoresist material, following pattern delineation, be evenly and completely removed from all exposed and unexposed areas so as to permit further operations. Even the partial remains of a resist coating in an area to be processed is undesirable as the left over residue of the photoresist material can have a detrimental effect on the yield of acceptable integrated circuits.

The complete removal of the photoresist after pattern transfer is accomplished in 1M or greater solutions of sodium or potassium hydroxide at elevated temperatures, often with an antitarnishing additive to limit oxidation of the copper. Thus, in general, these materials exhibit excellent stability in acidic solution, but they do have varying stability to more strongly acid and alkaline solutions. In fact, there are subclasses of materials: for acid etching of copper and for alkaline (ammoniacal usual) etching of copper. Increased acid stability is required for use in acid copper plating in which the pHs of the solutions often are below 1.

Additionally resist materials can be removed by one or more of the following: halogenated hydrocarbons, such as methylene chloride, amines and their derivatives, such as dimethylsulfoxide, dimethylformamide, N-methyl-2-pyrrolidinone, glycol ethers, such as ethylene glycol monomethyl ether, ethanol, ketones, such as methylethyl ketone and acetone and materials, such as isopropyl alcohol, sulphuric acid, ammonium persulfate and mixtures of caustic and phenol derivatives, as well as various other materials.

Dry-film photoresists are generally used for pattern formation prior to both plating and etching. These films have a three-layer structure, with the photosensitive material sandwiched between a polyester coversheet and a polyethylene separator sheet.

Liquid photoresists come in a variety of chemistries. Many are simply coatable forms of the dry-film materials. They have been used primarily for patterning innerlayers and are applied to the substrate by roller, spray, curtain, or electrostatic coating techniques. Applied thickness is typically 6 to 15 µm, giving superior resolution compared to dry-film resists that are generally thicker. Since resolution is approximated by the thickness, they have the potential to resolve features less than 25 µm. Conformation of liquid photoresist to the copper substrate is generally very good, and it is possible to achieve high yield at 50 µm features and less.

Alkali-soluble resist inks are generally preferred. Stripping in the case of thermal and UV-curable resists is accomplished in 2 weight % sodium hydroxide or in proprietary solutions. The resist is loosened and rinsed off with a water spray. Adequate safety precautions must be taken, since caustics are harmful. Conveyorized resist-stripping and etching machines use high-pressure pumping systems that spray hot alkaline solutions on both sides of the boards. Certain laminate materials such as the polyimides may be attached by alkaline strippers: Measling, staining, or other degradation is noted when strippers attack epoxy or other substrates. Control of concentration, temperature, and dwell time usually can prevent serious problems. Screened vinyl-based resists are removed by a dissolving action in solutions of chlorinated, petroleum, or glycol ether solvents. Methylene chloride and toluene (both currently not usable) were used extensively in cold stripper formulations.

WO 95/23999 discloses aqueous compositions for removing polymer resist layers containing a base and a soluble silicate, for example ethanol amine and sodium orthosilicate (Example 2) or potassium hydroxide and sodiumsilicate (Example 4).

US 5,102,777 describes a photoresist stripper composition containing an amine and a fatty acid.

The common equipment for stripping is spray conveyorized, either horizontally or vertically. Additives are used in the developer solutions to prevent foaming.

The stripping solution swells and dissolves the photoresist, stripping it either in sheets or as small particles. The equipment design must effectively remove and separate the skins. Often, brushes and ultrasonic agitation are added to aid in the resist removal. As with developing, filtration is important to keep the spray nozzles clean and keep fresh solution reaching the panel. For stripper chemistries that oxidize the copper, an antitarnishing agent is often added either to the stripping solution or as part of the rinsing.

One problem with the use of such photoimageable compositions as photoresists is that they are difficult to strip from electrolytically plated circuit boards using conventional alkaline aqueous stripping solutions, e.g., 3 weight % NaOH solution. This problem arises from the recent demand on circuit board manufacturers to reduce the size of printed circuit boards, while also increasing their functional capabilities. Consequently, the circuit lines and spaces on the circuit boards have continued to shrink, as more circuitry needs to be fit onto smaller surfaces.

This applies particularly to fine line high-density interconnect (HDI) feature sizes of 50 µm and today even 25 µm or lower. The sizes particular relate to the US value. The US value determines the width of a conductor track (L) and the space (S) between two conductor tracks. Fine line applications are typically described by US-values of 50 µm or lower for the L and S-value, more particular 25 µm or lower for the L and S-value. Although in most cases, the L and S value are the same, also values of 50 µm, / 25 µm, 30 µm / 25 µm, 25 µm / 50 µm etc. are possible.

The majority use organic-based (amine- or organic solvent-containing) alkaline stripping solutions, which produce a smaller stripped particle to facilitate stripping. While these organic strippers, e.g., solutions containing trimethylamine or tetramethylammonium hydroxide, remove the resist better, they are expensive (relative to NaOH or KOH) and have more waste treatment and environmental concerns associated with them. Moreover, due to the recent emphasis on reducing solvent emissions in the workplace, solvent-strippable photoresists are much less desirable than those that are aqueous-strippable.

EP 1 043 629 describes a photoresist stripping composition comprising a nitrogen-containing organohydroxyl compound, an alkylene glycol monoalkyl ether represented by the general formula: HO-(CₚH2ₚO)_{q}-R, wherein R is C1-C4 alkyl, p is 2 or 3, and q is 1, 2 or 3, sugar or sugar alcohol, a phosphoruscontaining compound and water.

The document EP 0 547 488 discloses a two-step method for the removal of photoresist films on a substrate comprising: a) treating the substrate with an aqueous solution containing a base, and b) thereafter further treating the substrate with a commercial aqueous stripping solution containing a base, a quaternary ammonium salt, and a glycol ether.

It is an object of the present invention to provide a method for efficient and residue-free removal of photoresist films on a substrate, particular suitable for fineline photoresist films featuring sizes of 50 µm, preferably 25 µm or lower.

It is a further object of the invention to enhance the lifetime of solutions applied particularly suited for fineline stripping.

Thus, the present invention applies a 2-step stripping process comprising the following stripping steps:
a) treating the substrate with an aqueous solution containing a base,
b) thereafter further treating the substrate with a solution containing a base and at least one stripping enhancer selected from the group consisting of hexylene glycol, ethylene glycol monoethyl ether, ethylene glycol monobutyl ether, ethylene glycol monoisopropyl ether, propylene glycol monomethyl ether, propylene glycol monoethyl ether, propylene glycol monobutyl ether, diethylene glycol monomethyl ether, diethylene glycol monoethyl ether, diethylene glycol monopropyl ether, diethylene glycol monobutyl ether, dipropylene glycol monomethyl ether, dipropylene glycol monoethyl ether; dipropylene glycol monopropyl ether, dipropylene glycol monobutyl ether, triethylene glycol monomethyl ether, triethylene glycol monoethyl ether, triethylene glycol monopropyl ether, triethylene glycol monobutyl ether, tripropylene glycol monomethyl ether, tripropylene glycol monoethyl ether, tripropylene glycol monopropyl ether, tripropylene glycol monobutyl ether, diethylenglycolmonoisopropyl ether and propylene glycol monomethyl ether acetate
to achieve complete removal of the photoresist film while at the same time enhancing the lifetime of the more valuable fineline stripping solution.

Pre- and post-treatment steps like rinsing etc. may be applied to further improve the stripping results.

The first stripping solution contains a base, preferably a metal hydroxide like sodium or potassium hydroxide. The content of the hydroxide is 0.05 - 15 weight %, preferably 1-5 weight %.

As a base, also amines may be used.

Examples of such amines comprise amines of the general formula

NR₃R₄R₅

wherein R₃, R₄ and R₅ are the same or different and are hydrogen or alkyl or hydroxyalkyl groups of 1 to 18 carbon atoms, phenyl, alkylphenyl or hydroxyalkylphenyl wherein the alkyl is of 1 to 18 carbon atoms. Specific examples of amines include trimethyl amine, triethyl amine, benzyl dimethyl amine, phenyl dimethyl amine, dodecyl dimethyl amine, hexadecyl dimethyl amine, octadecyl dimethyl amine, dodecyl diethyl amine, hexadecyl diethyl amine, octadecyl diethyl amine, dodecyl di-n-propyl amine, dodecyl di-isopropyl amine, benzyl methyl hexadecyl amine, methyl ethyl hexadecyl amine, p-dodecylbenzyl dimethyl amine, and benzyl methyl octadecyl amine.

Examples for preferred alkanolamines comprise triethanol amine, diethanol amine, dipropyl amine, methanol diethanol amine, propanol diethanol amine and propanol ethanol amine.

The content of the amine is 0.05 - 35 weight %, preferably 1-10 weight %.

Optionally, the stripping solution additionally contains a soluble silicate, for example sodium orthosilicate, sodium silicate, potassium orthosilicate or potassium silicate. Optionally, also copper complexing agents like sodium gluconate, sodium phosphonate, EDTA etc. may be applied.

The solution is sprayed onto the substrate having the photoresist film on its surface at a pressure of 1.0 - 10.0 bar, preferably 1.5 - 5.0 bar and at a temperature of 30° - 90°C, preferably 40° - 70°C. Treating time is 10 seconds - 10 minutes, preferably 30 seconds - 3 minutes. Thereafter, the substrate is preferably rinsed in water. Investigation with a Fluorescence Microscope at a 200-fold magnification shows that although most of the photoresist film has been removed, residues remain on the substrate in an amount not tolerable for further processing.

The substrate is then treated in a second stripping solution which contains again a base and additionally a stripping enhancer as defined above.

According to a preferred embodiment of the method according to the invention, the second stripping solution further comprises quaternary ammonium salts and/or a compound selected from the group consisting of triazoles, benzotriazoles, imidazoles and tetrazoles as a stripping enhancer.

The base can be selected from hydroxides and amines according to step 1 a) of the process and described in detail above. Hydroxides as bases are preferred.

The quaternary ammonium salts have the general formula

NR₁R₂R₃ R₄X,

wherein R₁, R₂ and R₃ and R₄ are the same or different and are selected from the group consisting of alkyl, hydroxyalkyl, phenyl, alkylphenyl and hydroxyalkylphenyl, wherein alkyl has 1 to 18 carbon atoms and wherein X is selected from the group consisting of anions, preferably hydroxide, sulfate and halide. Preferred examples of quaternary ammonium salts are tetramethylammonium hydroxide, choline hydroxide, and trishydroxyethylmethylammonium hydroxide. A preferred imidazole compound is benzimidazole. 5-aminotetrazole, 5-phenyltetrazole, benzotriazole, methylbenzotriazole and ethylbenzotriazole are also preferred compounds.

Preferred stripping enhancers as defined in claim 1 are not volatile at process temperatures and possess boiling points higher than 90°C.

According to a preferred embodiment of the invention, a stripping enhancer is used in step b) which comprises a mixture of hexylene glycol and ethylene glycol monoisopropyl ether. More preferably, these compounds are contained in an amount of 5 to 10% by weight based on the total amount of the solution used in step b).

The solution according to process step b) is sprayed onto the substrate having the photoresist film on its surface at a pressure of 1.0 - 10.0 bar, preferably 1.5 - 5.0 bar and at a temperature of 30° - 90°C, preferably 40° - 70°C. Treating time is 0.5 - 10 minutes, preferably 0.5 - 3 minutes.

Optionally, the stripping solution used in step b) additionally contains a soluble silicate, for example, sodium orthosilicate, sodium silicate, potassium orthosilicate or potassium silicate.

The invention is further explained by the following examples:
The sample boards are BGA coupons coated with the Dryfilm resist-type Morton SIT 2025. The Sample A has a resolution of 30 µm US and the Sample B has a resolution of 15 µm US.
Both samples were investigated after the resist stripping with a fluorescence microscope on resist residues and visible inspection on surface cosmetics.

### Example 1 (comparative):

The Sample A is sprayed at 1.5 bar with a solution consisting of 30 g/l KOH in water at 60°C for 1 min. Some parts of the resist coating are stripped in sheets from the sample into the stripper solution. After rinsing and drying the sample is investigated with a fluorescence microscope at a 200 x magnification. As a result, the Sample A shows resist residues all over. The stripping results are unsatisfactory. A cascade of further treatment steps is required in order to remove at least the majority of resist film on the board surface. Even then, stripping is not complete.

### Example 2 (comparative):

Sample A is sprayed at 1.5 bar with a solution consisting of 30 g/l monoethanolamine, 5 g/l tetramethylammonium hydroxide and 5 g/l cholinehydroxide and 0.5 g/l benzotriazole in water at 60°C for 1 min. The resist is stripped from the sample in 4 - 5 mm particles into the solution. After rinsing and drying the sample is investigated with a fluorescence microscope at 200 x magnification. As a result, the Sample A shows some resist residue particles left and a good copper surface cosmetics in the stripped areas. However, the stripping results are unsatisfactory. A cascade of further treatment steps is required in order to remove at least the majority of resist film on the board surface. Even then, stripping is not complete.

### Example 3:

Sample B is sprayed at 1.5 bar in a first step with a solution consisting of 30 g/l KOH in water at 60°C for 1 min. After that the Sample A is sprayed at 1.5 bar in a second step with a solution consisting of 30 g/l KOH and 100 ml/l of diethylene glycol monobutyl ether in water at 60°C for 1 min. The resist is stripped from the Sample B in sheets into the stripper solution during the first step and in 0.5 - 1 mm particles during the second step into the stripper solution. After rinsing and drying the sample is investigated with a fluorescence microscope at a 200 x magnification. As a results the Sample A shows no resist residues and a good copper surface cosmetics in the stripped areas. One would consider the stripping result excellent.

## Claims

1. A method for the removal of photoresist films on a substrate comprising the following steps:
a) treating the substrate with an aqueous solution containing a base,
b) thereafter further treating the substrate with a solution containing a base and at least one stripping enhancer selected from the group consisting of hexylene glycol, ethylene glycol monoethyl ether, ethylene glycol monobutyl ether, ethylene glycol monoisopropyl ether, propylene glycol monomethyl ether, propylene glycol monoethyl ether, propylene glycol monobutyl ether, diethylene glycol monomethyl ether, diethylene glycol monoethyl ether, diethylene glycol monopropyl ether, diethylene glycol monobutyl ether, dipropylene glycol monomethyl ether, dipropylene glycol monoethyl ether, dipropylene glycol monopropyl ether, dipropylene glycol monobutyl ether, triethylene glycol monomethyl ether, triethylene glycol monoethyl ether, triethylene glycol monopropyl ether, triethylene glycol monobutyl ether, tripropylene glycol monomethyl ether, tripropylene glycol monoethyl ether, tripropylene glycol monopropyl ether, tripropylene glycol monobutyl ether, diethylenglycolmonoisopropyl ether and propylene glycol monomethyl ether acetate.

2. The method according to claim 1 wherein the solution used in step b) further comprises quaternary ammonium salts and/or a compound selected from the group consisting of triazoles, benzotriazoles, imidazoles and tetrazoles.

3. The method according to claim 1 wherein the solution used in step b) contains 5 to 10% by weight ethylene glycol monoisopropyl ether and 5 to 10% by weight diethylene glycol monobutyl ether based on the total amount of the solution used in step b).

4. The method according to claim 1 wherein the base contained in the solution used in step a) is a hydroxide, preferably sodium or potassium hydroxide.

5. The method according to claim 4 wherein the hydroxide is contained in the solution used in step a) in an amount of 0.05 to 15% by weight, preferably in an amount of 1 to 5% by weight based on the total amount of the solution used in step a).

6. The method according to claim 1 wherein the base contained in the solution used in step a) is an amine of the general formula
NR₃R₄R₅
wherein R₃, R₄ and R₅ are the same or different and are hydrogen or alkyl or hydroxyalkyl groups of 1 to 18 carbon atoms, phenyl, alkylphenyl or hydroxyalkylphenyl wherein the alkyl is of 1 to 18 carbon atoms.

7. The method according to claim 6 wherein the amine is selected from the group consisting of trimethyl amine, triethyl amine, benzyl dimethyl amine, phenyl dimethyl amine, dodecyl dimethyl amine, hexadecyl dimethyl amine, octadecyl dimethyl amine, dodecyl diethyl amine, hexadecyl diethyl amine, octadecyl diethyl amine, dodecyl di-n-propyl amine, dodecyl di-isopropyl amine, benzyl methyl hexadecyl amine, methyl ethyl hexadecyl amine, p-dodecylbenzyl dimethyl amine, and benzyl methyl octadecyl amine.

8. The method according to claim 6 wherein the amine is an alkanol amine selected from the group consisting of triethanol amine, diethanol amine, dipropyl amine, methanol diethanol amine, propanol diethanol amine and propanol ethanol amine.

9. The method according to the claims 6 to 8 wherein the solution contains the amine in an amount of 0.05 to 35 weight %, preferably 1 to 10 weight % based on the total amount of the solution used in step a).

10. The method according to any of the preceding claims wherein the solution in step a) additionally contains a soluble silicate, preferably sodium orthosilicate or sodium silicate.

11. The method according to any of the preceding claims wherein the solution in step b) additionally contains a soluble silicate, preferably sodium orthosilicate or sodium silicate.

12. The method according to any of the preceding claims wherein the solution in step a) additionally contains a copper complexing agent, preferably sodium gluconate, sodium phosphonate or EDTA.

13. The method according to any of the preceding claims wherein the solution in step a) is sprayed onto the substrate having the photoresist film on its surface at a pressure of 1.0 - 10.0 bar, preferably 1.5 - 5.0 bar and at a temperature of 30° - 90°C, preferably 40° - 70°C and a treating time of 10 seconds - 10 minutes, preferably 30 seconds - 3 minutes.

14. The method according to any of the preceding claims wherein the solution in step b) contains either a base according to the claims 4 to 5 or a base according to the claims 6 to 9.

15. The method according to claims 2 to 14 wherein the quarternary ammonium salts have the general formula
NR₁R₂R₃ R₄X
wherein R₁, R₂ and R₃ and R₄ are the same or different and are selected from the group consisting of alkyl, hydroxyalkyl, phenyl, alkylphenyl and hydroxyalkylphenyl, wherein alkyl has 1 to 18 carbon atoms and wherein X is selected from the group consisting of anions, preferably hydroxide, sulfate and halide.

16. The method according to claim 15 wherein the at least one quaternary ammonium salt is selected from the group consisting of tetramethylammonium hydroxide, choline hydroxide and trishydroxyethylmethylammonium hydroxide.

17. The method according to the claims 15 to 16 wherein the concentration of the at least one quaternary ammonium salt in the solution is 2% to 35 weight %, preferably 2% to 10 weight % based on the total amount of the solution used in step b).

18. The method according to claims 2 to 17 wherein the solution used in step b) comprises benzimidazole, 5-aminotetrazole, 5-phenyltetrazole, benzotriazole, methylbenzotriazole and/or ethylbenzotriazole.

19. The method according to claim 1 wherein the stripping enhancer is not volatile at process temperatures and possesses boiling points higher than 90°C.

20. The method according to any of the preceding claims wherein the solution in step b) is sprayed onto the substrate having the photoresist film on its surface at a pressure of 1.0 - 10.0 bar, preferably 1.5 - 5.0 bar and at a temperature of 30° - 90°C, preferably 40° - 70°C and a treating time of 0.5 - 10 minutes, preferably 0.5 - 3 minutes.

21. The method according to any of the preceding claims wherein a substrate is used having a US value of less than 50 µm, preferably of less than 25 µm for the L- and S-value.

22. The method according to any of the preceding claims wherein a printed circuit board is used as a substrate.

## Patentansprüche

1. Verfahren für die Entfernung von Photoresist-Filmen auf einem Substrat, umfassend die folgenden Schritte:
a) Behandeln des Substrats mit einer wässrigen Lösung, die eine Base enthält,
b) danach weiteres Behandeln des Substrats mit einer Lösung, die eine Base und wenigstens einen Abziehverstärker (stripping enhancer), ausgewählt aus der Gruppe, bestehend aus Hexylenglykol, Ethylenglykolmonoethylether, Ethylenglykolmonobutylether, Ethylenglykolmonoisopropylether, Propylenglykolmonomethylether, Propylenglykolmonoethylether, Propylenglykolmonobutylether, Diethylenglykolmonomethylether, Diethylenglykolmonoethylether, Diethylenglykolmonopropylether, Diethylenglykolmonobutylether, Dipropylenglykolmonomethylether, Dipropylenglykolmonoethylether, Dipropylenglykolmonopropylether, Dipropylenglykolmonobutylether, Triethylenglykolmonomethylether, Triethylenglykolmonoethylether, Triethylenglykolmonopropylether, Triethylenglykolmonobutylether, Tripropylenglykolmonomethylether, Tripropylenglykolmonoethylether, Tripropylenglykolmonopropylether, Tripropylenglykolmonobutylether, Diethylenglykolmonoisopropylether und Propylenglykolmonomethyletheracetat, enthält.

2. Verfahren gemäß Anspruch 1, wobei die in Schritt b) verwendete Lösung außerdem quaternäre Ammoniumsalze und/oder eine Verbindung, ausgewählt aus der Gruppe, bestehend aus Triazolen, Benzotriazolen, Imidazolen und Tetrazolen, umfasst.

3. Verfahren gemäß Anspruch 1, wobei die in Schritt b) verwendete Lösung 5 bis 10 Gew.-% Ethylenglykolmonoisopropylether und 5 bis 10 Gew.-% Diethylenglykolmonobutylether, bezogen auf die Gesamtmenge der in Schritt b) verwendeten Lösung, enthält.

4. Verfahren gemäß Anspruch 1, wobei die Base, die in der in Schritt a) verwendeten Lösung enthalten ist, ein Hydroxid, vorzugsweise Natrium- oder Kaliumhydroxid, ist.

5. Verfahren gemäß Anspruch 4, wobei das Hydroxid in der in Schritt a) verwendeten Lösung in einer Menge von 0,05 bis 15 Gew.-%, vorzugsweise in einer Menge von 1 bis 5 Gew.-%, bezogen auf die Gesamtmenge der in Schritt a) verwendeten Lösung, enthalten ist.

6. Verfahren gemäß Anspruch 1, wobei die Base, die in der in Schritt a) verwendeten Lösung enthalten ist, ein Amin der allgemeinen Formel
NR₃R₄R₅
ist,
worin R₃, R₄ und R₅ gleich oder unterschiedlich sind und Wasserstoff oder Alkyl- oder Hydroxyalkylgruppen mit 1 bis 18 Kohlenstoffatomen, Phenyl, Alkylphenyl oder Hydroxyalkylphenyl, worin das Alkyl 1 bis 18 Kohlenstoffatome hat, sind.

7. Verfahren gemäß Anspruch 6, wobei das Amin ausgewählt ist aus der Gruppe, bestehend aus Trimethylamin, Triethylamin, Benzyldimethylamin, Phenyldimethylamin, Dodecyldimethylamin, Hexadecyldimethylamin, Octadecyldimethylamin, Dodecyldiethylamin, Hexadecyldiethylamin, Octadecyldiethylamin, Dodecyldin-propylamin, Dodecyldiisopropylamin, Benzylmethylhexadecylamin, Methylethylhexadecylamin, p-Dodecylbenzyldimethylamin und Benzylmethyloctadecylamin.

8. Verfahren gemäß Anspruch 6, wobei das Amin ein Alkanolamin ist, das aus der Gruppe, bestehend aus Triethanolamin, Diethanolamin, Dipropylamin, Methanoldiethanolamin, Propanoldiethanolamin und Propanolethanolamin, ausgewählt wird.

9. Verfahren gemäß den Ansprüchen 6 bis 8, wobei die Lösung das Amin in einer Menge von 0,05 bis 35 Gew.-%, vorzugsweise 1 bis 10 Gew.-%, bezogen auf die Gesamtmenge der in Schritt a) verwendeten Lösung, enthält.

10. Verfahren gemäß einem der vorangehenden Ansprüche, wobei die Lösung in Schritt a) zusätzlich ein lösliches Silikat, vorzugsweise Natriumorthosilikat oder Natriumsilikat, enthält.

11. Verfahren gemäß einem der vorangehenden Ansprüche, wobei die Lösung in Schritt b) zusätzlich ein lösliches Silikat, vorzugsweise Natriumorthosilikat oder Natriumsilikat, enthält.

12. Verfahren gemäß einem der vorangehenden Ansprüche, wobei die Lösung in Schritt a) zusätzlich ein Kupfer komplexierendes Mittel, vorzugsweise Natriumgluconat, Natriumphosphonat oder EDTA, enthält.

13. Verfahren gemäß einem der vorangehenden Ansprüche, wobei die Lösung in Schritt a) auf das Substrat, das den Photoresist-Film auf seiner Oberfläche hat, mit einem Druck von 1,0 bis 10,0 Bar, vorzugsweise 1,5 bis 5,0 Bar und bei einer Temperatur von 30° bis 90°C, vorzugsweise 40° bis 70°C und einer Behandlungszeit von 10 Sekunden bis 10 Minuten, vorzugsweise 30 Sekunden bis 3 Minuten, gesprüht wird.

14. Verfahren gemäß einem der vorangehenden Ansprüche, wobei die Lösung in Schritt b) entweder eine Base gemäß den Ansprüchen 4 bis 5 oder eine Base gemäß den Ansprüchen 6 bis 9 enthält.

15. Verfahren gemäß den Ansprüchen 2 bis 14, wobei die quaternären Ammoniumsalze die allgemeine Formel
NR₁R₂R₃R₄X
haben, worin R₁, R₂ und R₃ und R₄ gleich oder unterschiedlich sind und aus der Gruppe, bestehend aus Alkyl, Hydroxyalkyl, Phenyl, Alkylphenyl und Hydroxyalkylphenyl, worin Alkyl 1 bis 18 Kohlenstoffatome hat, ausgewählt sind und worin X aus der Gruppe, bestehend aus Anionen, vorzugsweise Hydroxid, Sulfat und Halogenid, ausgewählt wird.

16. Verfahren gemäß Anspruch 15, wobei das wenigstens eine quaternäre Ammoniumsalz aus der Gruppe, bestehend aus Tetramethylammoniumhydroxid, Cholinhydroxid und Trishydroxyethylmethylammoniumhydroxid, ausgewählt wird.

17. Verfahren gemäß den Ansprüchen 15 bis 16, wobei die Konzentration des wenigstens einen quaternären Ammoniumsalzes in der Lösung 2 Gew.-% bis 35 Gew.-%, vorzugsweise 2 Gew.-% bis 10 Gew.-%, bezogen auf die Gesamtmenge der in Schritt b) verwendeten Lösung, ist.

18. Verfahren gemäß den Ansprüchen 2 bis 17, wobei die in Schritt b) verwendete Lösung Benzimidazol, 5-Aminotetrazol, 5-Phenyltetrazol, Benzotriazol, Methylbenzotriazol und/oder Ethylbenzotriazol umfasst.

19. Verfahren gemäß Anspruch 1, wobei der Abziehverstärker bei Verfahrenstemperaturen nicht flüchtig ist und Siedepunkte von höher als 90°C besitzt.

20. Verfahren gemäß einem der vorangehenden Ansprüche, wobei die Lösung in Schritt b) auf das Substrat, das den Photoresist-Film auf seiner Oberfläche hat, mit einem Druck von 1,0 bis 10,0 Bar, vorzugsweise 1,5 bis 5,0 Bar und bei einer Temperatur von 30° bis 90°C, vorzugsweise 40° bis 70°C und einer Behandlungszeit von 0,5 bis 10 Minuten, vorzugsweise 0,5 bis 3 Minuten, gesprüht wird.

21. Verfahren gemäß einem der vorangehenden Ansprüche, wobei ein Substrat verwendet wird, das einen L/S-Wert von kleiner als 50 µm, vorzugsweise kleiner als 25 µm für den L- und S-Wert hat.

22. Verfahren gemäß einem der vorangehenden Ansprüche, wobei eine gedruckte Leiterplatte als Substrat verwendet wird.

## Revendications

1. Procédé d'élimination de films de réserve photosensible sur un substrat, comprenant les étapes suivantes :
a) le traitement du substrat avec une solution aqueuse contenant une base,
b) puis le traitement supplémentaire du substrat avec une solution contenant une base et au moins un agent renforçant le décapage choisi dans le groupe constitué par l'hexylène glycol, l'éthylène glycol monoéthyl éther, l'éthylène glycol monobutyle éther, l'éthylène glycol monoisopropyl éther, le propylène glycol monométhyl éther, le propylène glycol monoéthyl éther, le propylène glycol monobutyl éther, le diéthylène glycol monométhyl éther, le diéthylène glycol monoéthyl éther, le diéthylène glycol monopropyl éther, le diéthylène glycol monobutyl éther, le dipropylène glycol monométhyl éther, le dipropylène glycol monoéthyl éther, le dipropylène glycol monopropyl éther, le dipropylène glycol monobutyl éther, le triéthylène glycol monométhyl éther, le triéthylène glycol monométhyl éther, le triéthylène glycol monopropyl éther, le triéthylène glycol monobutyl éther, le tripropylène glycol monométhyl éther, le tripropylène glycol monométhyl éther, le tripropylène glycol monopropyl éther, le tripropylène glycol monobutyl éther, le diéthylène glycol monoisopropyl éther et l'acétate de propylène glycol monométhyl éther.

2. Procédé selon la revendication 1, dans lequel la solution utilisée dans l'étape b) comprend en outre des sels d'ammonium quaternaire et/ou un composé choisi dans le groupe constitué par les triazoles, les benzotriazoles, les imidazoles et les tétrazoles.

3. Procédé selon la revendication 1, dans lequel la solution utilisée dans l'étape b) contient 5 % en poids à 10 % en poids d'éthylène glycol monoisopropyl éther et 5 % en poids à 10 % en poids de diéthylène glycol monobutyl éther, sur la base de la quantité totale de la solution utilisée dans l'étape b).

4. Procédé selon la revendication 1, dans lequel la base contenue dans la solution utilisée dans l'étape a) est un hydroxyde, de préférence l'hydroxyde de sodium ou de potassium.

5. Procédé selon la revendication 4, dans lequel l'hydroxyde est contenu dans la solution utilisée dans l'étape a) en une quantité de 0,05 % en poids à 15 % en poids, de préférence en une quantité de 1 % en poids à 5 % en poids, sur la base de la quantité totale de la solution utilisée dans l'étape a).

6. Procédé selon la revendication 1, dans lequel la base contenue dans la solution utilisée dans l'étape a) est une amine de formule générale :
NR₃R₄R₅
dans laquelle R₃, R₄ et R₅ sont identiques ou différents et sont un hydrogène ou un groupe alkyle ou hydroxyalkyle contenant 1 à 18 atomes de carbone, un phényle, un alkylphényle ou un hydroxyalkylphényle, dans lequel l'alkyle contient 1 à 18 atomes de carbone.

7. Procédé selon la revendication 6, dans lequel l'amine est choisie dans le groupe constitué par la triméthyl amine, la triéthyl amine, la benzyl diméthyl amine, la phényl diméthyl amine, la dodécyl diméthyl amine, l'hexadécyl diméthyl amine, l'octadécyl diméthyl amine, la dodécyl diéthyl amine, l'hexadécyl diéthyl amine, l'octadécyl diéthyl amine, la dodécyl di-n-propyl amine, la dodécyl di-isopropyl amine, la benzyl méthyl hexadécyl amine, la méthyl éthyl hexadécyl amine, la p-dodécylbenzyl diméthyl amine et la benzyl méthyl octadécyl amine.

8. Procédé selon la revendication 6, dans lequel l'amine est une alcanol amine choisie dans le groupe constitué par la triéthanol amine, la diéthanol amine, la dipropyl amine, la méthanol diéthanol amine, la propanol diéthanol amine et la propanol éthanol amine.

9. Procédé selon les revendications 6 à 8, dans lequel la solution contient l'amine en une quantité allant de 0,05 % en poids à 35 % en poids, de préférence de 1 % en poids à 10 % en poids, sur la base de la quantité totale de la solution utilisée dans l'étape a).

10. Procédé selon l'une quelconque des revendications précédentes, dans lequel la solution de l'étape a) contient en outre un silicate soluble, de préférence l'orthosilicate de sodium ou le silicate de sodium.

11. Procédé selon l'une quelconque des revendications précédentes, dans lequel la solution de l'étape b) contient en outre un silicate soluble, de préférence l'orthosilicate de sodium ou le silicate de sodium.

12. Procédé selon l'une quelconque des revendications précédentes, dans lequel la solution de l'étape a) contient en outre un agent complexant le cuivre, de préférence le gluconate de sodium, le phosphonate de sodium ou l'EDTA.

13. Procédé selon l'une quelconque des revendications précédentes, dans lequel la solution de l'étape a) est pulvérisée sur le substrat ayant le film de réserve photosensible sur sa surface à une pression de 1,0 bar à 10,0 bars, de préférence de 1,5 bar à 5,0 bars, et à une température de 30 °C à 90 °C, de préférence de 40 °C à 70 °C, et pendant une durée de traitement de 10 secondes à 10 minutes, de préférence de 30 secondes à 3 minutes.

14. Procédé selon l'une quelconque des revendications précédentes, dans lequel la solution de l'étape b) contient soit une base selon les revendications 4 à 5, soit une base selon les revendications 6 à 9.

15. Procédé selon les revendications 2 à 14, dans lequel les sels d'ammonium quaternaire ont la formule général :
NR₁R₂R₃R₄X
dans laquelle R₁, R₂ et R₃ et R₄ sont identiques ou différents et sont choisis dans le groupe constitué par un alkyle, un hydroxyalkyle, un phényle, un alkylphényle et un hydroxyalkylphényle, dans lequel l'alkyle contient 1 à 18 atomes de carbone et dans lequel X est choisi dans le groupe constitué par les anions, de préférence un hydroxyde, un sulfate ou un halogénure.

16. Procédé selon la revendication 15, dans lequel ledit au moins un sel d'ammonium quaternaire est choisi dans le groupe constitué par l'hydroxyde de tétraméthyl ammonium, l'hydroxyde de choline et l'hydroxyde de trishydroxyéthylméthylammonium.

17. Procédé selon les revendications 15 à 16, dans lequel la concentration dudit au moins un sel d'ammonium quaternaire dans la solution est de 2 % en poids à 35 % en poids, de préférence de 2 % en poids à 10 % en poids, sur la base de la quantité totale de la solution utilisée dans l'étape b).

18. Procédé selon les revendications 2 à 17, dans lequel la solution utilisée dans l'étape b) comprend du benzimidazole, du 5-aminotétrazole, du 5-phényltétrazole, du benzotriazole, du méthylbenzotriazole et/ou de l'éthylbenzotriazole.

19. Procédé selon la revendication 1, dans lequel l'agent renforçant le décapage n'est pas volatil aux températures du procédé et possède un point d'ébullition supérieur à 90°C.

20. Procédé selon l'une quelconque des revendications précédentes, dans lequel la solution de l'étape b) est pulvérisée sur le substrat ayant le film de réserve photosensible sur sa surface à une pression de 1,0 bar à 10,0 bars, de préférence de 1,5 bar à 5,0 bars, et à une température de 30°C à 90 °C, de préférence de 40 °C à 70°C, et pendant une durée de traitement de 0,5 minute à 10 minutes, de préférence de 0,5 minute à 3 minutes.

21. Procédé selon l'une quelconque des revendications précédentes, dans lequel le substrat utilisé présente une valeur L/S inférieure à 50 µm, de préférence inférieure à 25 µm pour la valeur de L et de S.

22. Procédé selon l'une quelconque des revendications précédentes, dans lequel une carte de circuit imprimé est utilisée comme substrat.
